# EUROPÄISCHE PATENTSCHRIFT

(11) **EP 0 343 484 B1**
(45) Veröffentlichungstag und Bekanntmachung des Hinweises auf die Patenterteilung: **20.10.1993**
(21) Anmeldenummer: 89108777.7
(22) Anmeldetag: 16.05.1989
(51) Int. Cl.: H03K 17/945

(54) **Berührungsloser Näherungsschalter für Eisenbahnanlagen**
Touchless proximity switch for railway installations
Commutateur de proximité sans contact pour installations de chemin de fer

(30) Priorität: 27.05.1988 DE 3818090
(43) Veröffentlichungstag der Anmeldung: 29.11.1989
(73) Patentinhaber: SIEMENS AKTIENGESELLSCHAFT, 80333 München (DE)
(72) Erfinder: Graf, Rüdiger, Dipl.-Ing., D-3303 Vechelde (DE); Schmidt, Harald, Dipl.-Ing., D-3300 Braunschweig (DE)

(56) Entgegenhaltungen:
- DE-A- 3 643 970
- FR-A- 1 415 756
- GB-A- 1 249 043
- US-A- 3 887 850
- US-A- 4 344 071
- SIGNAL & DRAHT, Band 78, Nr. 12, Dezember 1986, Seiten 264-268; G. HOFFMANN et al.: "Das Radsenorsystem RS S als Zugeinwirkungspunkt"

## Beschreibung

Die Erfindung bezieht sich auf einen berührungslosen Näherungsschalter mit einem über eine Zweidrahtleitung ferngespeisten, durch Metallteile in seinen elektrischen Eigenschaften beeinflußbaren Sensor, dessen bei Beeinflussung änderbare Sensorspannung einen elektronischen Schwellwertschalter steuert, der ebenfalls an die Zweidrahtleitung angeschlossen ist und jede Beeinflussung mit einer Stromaufnahmeänderung quittiert.

Besonders im Eisenbahnsicherungswesen werden derartige Einrichtungen als Schienenkontakte zum Auslösen von Impulsen beim Passieren von Fahrzeugrädern eingesetzt. Die Impulse steuern Zähleinrichtungen, die an der Strecke oder in Stellwerken zusammen mit anderen eisenbahnsignaltechnischen Einrichtungen untergebracht sind. Nach dem Einzählen eines ersten Impulses einer diese Zähleinrichtung steuernden und am Anfang des betreffenden Gleisabschnittes angeordneten Sensoreinrichtung wird durch die Zähleinrichtung eine Besetztmeldung ausgegeben. Eine in Fahrrichtung am Ende des besagten Gleisabschnittes angeordnete weitere Sensoreinrichtung gibt beim Passieren von Fahrzeugrädern Auszählimpulse an die Zähleinrichtung, derart, daß nach dem Auszählen aller eingezählten Impulse der Gleisabschnitt wieder freigemeldet wird. Zum Bestimmen von richtungsabhängigen Zählimpulsen werden am Gleis dicht beieinander zwei Sensoreinrichtungen angeordnet, die aus Sicherheitsgründen über zwei Zweidrahtleitungen mit der entfernt liegenden Einrichtung verbunden sind. Diese Einrichtung stellt auch die Energieversorgung der zugeordneten Sensoreinrichtungen sicher. Da sich bei der Betätigung der Sensoreinrichtungen durch Auslösen des jeweiligen elektronischen Schwellwertschalters die Stromaufnahme auf der Zweidrahtleitung ändert, können aufgrund einer Bewertung der Speiseströme zentral die erforderlichen Zählimpulse generiert werden. Hierzu kann beispielsweise ein Fensterdiskriminator vorgesehen werden, der beim Vorhandensein eines vorgegebenen Betriebsstromes auf der Zweidrahtleitung kein Ausgangssignal, jedoch bei Abweichungen des Stromes um einen vorgegebenen Betrag vom Betriebsstrom einen diesbezüglichen Impuls auslöst. Auch ist es möglich, in der vom berührungslosen Näherungsschalter entfernt liegenden Zentrale zwischen die Zweidrahtleitung einen ohmschen Meßwiderstand einzufügen, an welchem der Speisestrom einen vorgegebenen Spannungsabfall hervorruft, der durch einen Schwellwertschalter zwecks Auslösung der Zählimpulse bewertet wird.

Ein berührungsloser Näherungsschalter der eingangs genannten Art ist in der DE-OS 33 27 329 als elektronisches, vorzugsweise berührungslos arbeitendes Schaltgerät näher beschrieben. Es soll anstelle von elektrischen, mechanisch betätigten Schaltgeräten in Meß-, Steuer- und Regelkreisen eingesetzt werden.

Werden derartige Näherungsschalter auf dem rauhen Gebiet des Eisenbahnsicherungswesens eingesetzt, müssen sie besonderen Zeitbedingungen genügen. Um bei höheren Fahrgeschwindigkeiten Impulse auszulösen, die eine vorgegebene zeitliche Dauer nicht unterschreiten, sind besondere schaltungstechnische Maßnahmen erforderlich. Diese Maßnahmen führen im allgemeinen zu einer unerwünschten Erhöhung der Stromaufnahme des Näherungsschalters, die jedoch aus verschiedenen Gründen nicht erwünscht bzw. nicht zulässig ist.

Der Erfindung liegt die Aufgabe zugrunde, einen berührungslosen Näherungsschalter der eingangs angegebenen Art so zu verbessern, daß auch bei kurzzeitigen Beeinflussungen von Hochgeschwindigkeitszügen Impulse ausgelöst werden, die eine vorgegebene zeitliche Dauer nicht unterschreiten. Dabei soll die Wiederbereitschaftszeit nach Abgabe eines Impulses möglichst klein sein, damit alle Räder eines schnell vorbeifahrenden Zuges mit Sicherheit erfaßt werden können.
Erfindungsgemäß wird die Aufgabe durch die im Anspruch 1 angegebenen Merkmale gelöst.
Ein derartiger berührungsloser Näherungsschalter gestattet bei geringem Strom- und Bauteileaufwand eine exakte Impulsverlängerung im Hinblick auf Impulse von mit hoher Geschwindigkeit passierenden Fahrzeugrädern. Weiterhin ist es von besonderem Vorteil, daß der erfindungsgemäße Näherungsschalter eine besonders kurze Wiederbereitschaftsdauer nach Abgabe eines Impulses erfordert, so daß Radbeeinflussungen in besonders schneller Folge in ordnungsgerechter Weise gemeldet werden können.

Weitere vorteilhafte Ausbildungen der Erfindung sind in den abhängigen Ansprüchen gekennzeichnet und im Rahmen der Beschreibung eines Ausführungsbeispieles der Erfindung näher erläutert.

Ein Ausführungsbeispiel der Erfindung ist in der Zeichnung dargestellt und wird nachfolgend näher erläutert.

Es zeigen:
- Figur 1: die Schaltung eines berührungslosen Näherungsschalters für Eisenbahnanlagen und
- Figur 2: in drei Diagrammlinien Spannungsverläufe in Abhängigkeit von kurzzeitigen bzw. längeren Beeinflussungen.

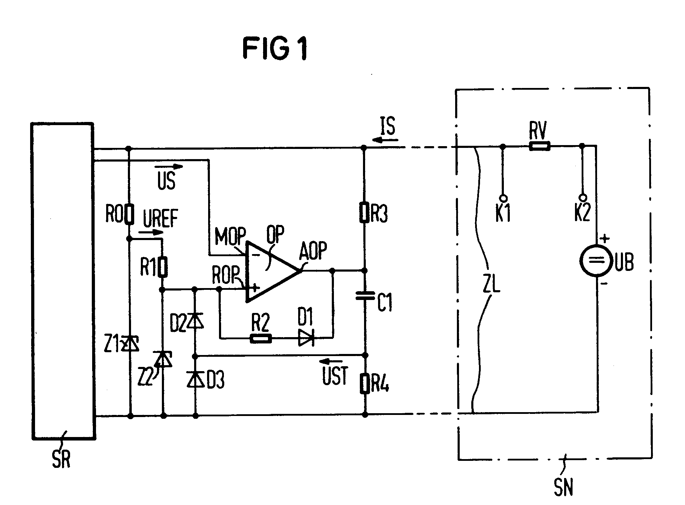

Die Anordnung nach Figur 1 zeigt einen berührungslosen Näherungsschalter, der über eine Zweidrahtleitung ZL an eine ortsfeste Station SN Informationen überträgt. Über dieselbe Zweidrahtleitung ZL erfolgt auch die Energierversorgung des Näherungsschalters aus einer Batterie UB. Aufgrund eines Modulationsvorganges des Sensorstromes IS durch Beeinflussungsvorgänge des berührungslosen Näherungsschalters werden diese der ortsfesten Station SN gemeldet. Zu dem Zweck kann eine am Vorwiderstand RV und an den Klemmen K1 und K2 abnehmbare Spannung ausgewertet werden.

Der an die Zweidrahtleitung ZL angeschlossene ferngespeiste Näherungsschalter besteht im wesentlichen aus zwei Baugruppen, nämlich dem eigentlichen Sensor SR und einem durch die vom Sensor SR abgegebene Sensorspannung US steuerbaren elektronischen Schwellwertschalter. Sowohl der Sensor SR als auch der elektronische Schwellwertschalter, der als aktives Element einen Operationsverstärker OP enthält, wird über die Zweidrahtleitung ZL ferngespeist. Dabei ist es aus betrieblichen Gründen wesentlich, daß die Stromaufnahme des berührungslosen Näherungsschalters besonders im Zustand der Meldung einer Beeinflussung gering ist.

Der Sensor SR ist bewußt nur als Symbol dargestellt, denn dessen elektronischer Aufbau kann von beliebiger Art sein. Wesentlich ist, daß er bei der Verwendung im Eisenbahnsignalwesen bei entsprechender Montage am Gleis aufgrund von passierenden Fahrzeugrädern sein elektrisches Verhalten derart ändert, daß bei jeder Beeinflussung eine Sensorspannung erzeugt wird, deren Amplitude sich von derjenigen ausreichend unterscheidet, die bei nicht beeinflußtem Sensor SR vorliegt. Zum Auswerten der Sensorspannung US dient der elektronische Schwellwertschalter mit dem Operationsverstärker OP, dessen Meßeingang MOP mit dem die Sensorspannung US führenden Ausgang des Sensors SR verbunden ist. Weiterhin wird dem Operationsverstärker OP über dessen Referenzeingang ROP und einen Widerstand R1 die Referenzspannung UREF einer aus einem Widerstand R0 sowie einer Zener-Diode Z1 bestehenden und an die Zweidrahtleitung ZL angeschlossenen Spannungsstabilisierungsschaltung zugeführt. Der Referenzeingang ROP ist über einen Widerstand R2 in Reihe mit einer Diode D1 mit dem Ausgang AOP des Operationsverstärkers OP verbunden. Durch diese Rückführung wird eine Hysterese im Schaltverhalten des Operationsverstärkers OP erzielt. Der Ausgang AOP des Operationsverstärkers OP, der vorzugsweise mit einem Offenen-Kollektor-Ausgang ausgestattet ist, ist über einen Widerstand R3 mit einer der beiden Leitungen der Zweidrahtleitung ZL und über die Reihenschaltung eines Kondensators C1 und eines weiteren Widerstandes R4 mit der anderen Leitung verbunden. Die am Widerstand R4 bei vorgegebenen Umladevorgängen des Kondensators C1 abfallenden Spannungen werden als Steuerspannung UST über eine Diode D2 zusätzlich dem Referenzeingang ROP des Operationsverstärkers OP zugeführt. Eine parallel zum Widerstand R4 geschaltete Diode D3 hat die Aufgabe zu verhindern, daß das am Referenzeingang ROP betriebsmäßig nach jeder Beeinflussung des Sensors SR entstehende Potential nicht unterhalb der negativen Batteriespannung gelangen kann. Eine weitere Zener-Diode Z2, die parallel zu den beiden Dioden D2 und D3 liegt, hat die Aufgabe, die am Referenzeingang ROP des Operationsverstärkers OP durch Überlagerung der Referenzspannung UREF und der Steuerspannung UST entstehende Summenspannung auf einen vorgegebenen Wert zu begrenzen.

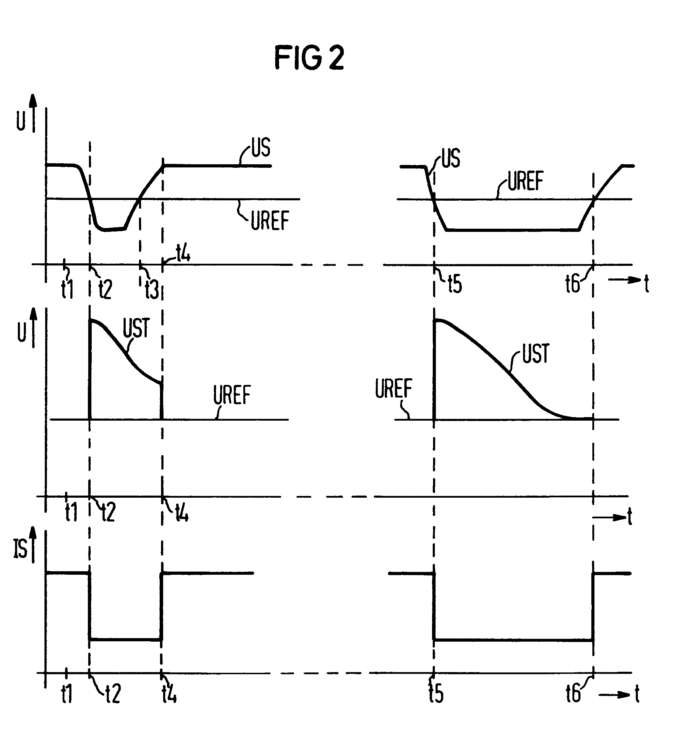

Die grundsätzliche Wirkungsweise des berührungslosen Näherungsschalters wird nun nachfolgend anhand der drei Diagrammlinien in Figur 2 näher erläutert. Diese zeigen jeweils im linken bzw. rechten Teil Signalverläufe, die bei einer sehr kurzzeitigen bzw. einer länger andauernden Beeinflussung des Sensors SR vorliegen.
Im oberen Diagramm von Figur 2 sind die Referenzspannung UREF und die Sensorspannung US in Abhängigkeit von der Zeit t aufgetragen. Das mittlere Diagramm zeigt den Verlauf der Steuerspannung UST in Verbindung mit der Referenzspannung UREF, während im unteren Diagramm von Figur 2 der Sensorstrom IS in Abhängigkeit von der Zeit t skizziert ist. Zum Zeitpunkt t1 möge noch keine Beeinflussung des Sensors SR vorliegen, so daß dessen Sensorspannung US größer ist als die Referenzspannung UREF. Dies hat zur Folge, daß der Ausgang AOP des Operationsverstärkers OP auf tiefem Potential liegt. Dabei ist der Kondensator C1 entladen. Etwa zum Zeitpunkt t2 sinkt die Sensorspannung US aufgrund einer Beeinflussung des Sensors SR unter den Wert der Referenzspannung UREF, so daß der Ausgangstransistor (nicht dargestellt) des Operationsverstärkers OP sperrt. Hierdurch wechselt das Potential am Ausgang AOP von tiefem auf hohes Potential. Dabei wird der Sensorstrom IS auf der Zweidrahtleitung ZL, wie in der unteren Diagrammlinie zu ersehen ist, abgesenkt. Gleichzeitig wird die sprungartig ansteigende Steuerspannung UST, vgl. den Verlauf nach dem Zeitpunkt t2 in der mittleren Diagrammlinie, der Referenzspannung UREF überlagert. Dies hat zur Folge, daß der Operationsverstärker OP nicht zum Zeitpunkt t3, bei welchem die Beeinflussung in etwa wieder abgeschlossen ist, in Grundstellung schaltet, sondern erst eine Zeit lang später, nämlich zum Zeitpunkt t4. Dies entspricht der gewünschten Impulsverlängerung bei sehr kurzen Beeinflussungsdauern des Sensors SR. Sobald der Ausgangstransistor des Operationsverstärkers OP zum Zeitpunkt t4 wieder durchschaltet und der Ausgang AOP somit dann auf tiefem Potential liegt, wird der Kondensator C1 niederohmig entladen. Dies ist ein besonderer Vorteil der Schaltung, da trotz der Eigenschaft einer Impulsverlängerung eine sehr kleine Wiederbereitschaftsdauer erzielt wird. Wie am Verlauf des Sensorstromes IS im unteren Diagramm zu erkennen ist, steigt der Sensorstrom nach dem Zeitpunkt t4 wieder auf den zum Zeitpunkt t1 innegehabten Wert an.

Wie eingangs bereits erläutert wurde, sind die jeweils im rechten Teil der drei Diagrammlinien in Figur 2 dargestellten Verläufe einem langsamen Beeinflussungsvorgang zugeordnet. Dieser beginnt zum Zeitpunkt t5 und ist nach einer Dauer, die wesentlich größer ist als die Dauer zwischen den Zeitpunkten t2 und t3, zum Zeitpunkt t6 beendet. Zu diesem Zeitpunkt ist die Steuerspannung UST bereits wieder abgeklungen, so daß das Schaltverhalten des Operationsverstärkers OP allein durch die Referenzspannung UREF bestimmt wird. In diesem Betriebsfall erfolgt also keine Impulsverlängerung. Auch in diesem Fall wird der Kondensator C1 nach dem Zeitpunkt t6 wieder niederohmig durch den Ausgangstransistor des Operationsverstärkers OP entladen, wobei der dabei am Widerstand R4 auftretende Spannungssprung - wie bei Vorgängen mit kurzen Beeinflussungsdauern vom Referenzeingang ROP durch die Diode D2 ferngehalten wird.

Zusammengefaßt sei noch einmal deutlich festgestellt, daß die erfindungsgemäße Schaltung des berührungslosen Näherungsschalters bei stets sehr kleiner Wiederbereitschaftsdauer nach beliebigen Beeinflussungen eine von der Beeinflußungsdauer abhängige Impulsverlängerung vornimmt, und zwar ausschließlich für solche Impulse, die aufgrund von sehr kurz andauernden Beeinflussungen ausgelöst werden und in der ortsfesten Station SN zu Fehlsteuerungen führen könnten.

## Patentansprüche

1. Berührungsloser Näherungsschalter mit einem über eine Zweidrahtleitung (ZL) aus einer Gleichspannungsquelle (UB) ferngespeisten, durch Metallteile in seinen elektrischen Eigenschaften beeinflußbaren Sensor (SR), dessen bei Beeinflussung änderbare Sensorspannung (US) einen elektronischen Schwellwertschalter steuert, der ebenfalls an die Zweidrahtleitung angeschlossen ist und jede Beeinflussung mit einer Stromaufnahmeänderung quittiert, dadurch gekennzeichnet, daß als Schwellwertschalter ein Operationsverstärker (OP) vorgesehen ist, dessem invertierenden Eingang (MOP) die Sensorspannung (US) zugeführt ist und dessen nichtinvertierender Eingang (ROP) über einen ersten Widerstand (R1) mit einer Referenzspannungsquelle (R0, Z1) und über einen zweiten Widerstand (R2) in Reihe mit einer ersten Diode (D1) mit dem Ausgang (AOP) des Operationsverstärkers (OP) verbunden ist, der ausgangsseitig über einen dritten Widerstand (R3) mit der positives Potential führenden Ader der Zweidrahtleitung (ZL) verbunden ist, daß der Ausgang (AOP) des Operationsverstärkers (OP) ferner über eine Kondensator-Widerstands-Reihenschaltung (C1, R4) an die negatives Potential führende Ader der Zweidrahtleitung (ZL) angeschlossen ist und daß der Verbindungspunkt dieser Widerstands-Kondensator-Reihenschaltung über eine zweite Diode (D2) mit dem nichtinvertierenden Eingang (ROP) des Operationsverstärkers verbunden ist, wobei diese Diode (D2) so geschaltet ist, daß sie den Stromfluß von der Referenzspannungsquelle (R0, Z1) über den ersten Widerstand (R1) und den Widerstand (R4) der Kondensator-Widerstands-Reihenschaltung (C1, R4) zu der negatives Potential führenden Ader der Zweidrahtleitung (ZL) sperrt.

2. Berührungsloser Näherungsschalter nach Anspruch 1, **dadurch gekennzeichnet**, daß die am nichtinvertierenden Eingang (ROP) des Operationsverstärkers (OP) auftreten-de Spannung durch eine Zener-Diode (Z2) auf einen vorgegebenen Wert begrenzt ist.

3. Berührungsloser Näherungsschalter nach Anspruch 1 oder 2, **dadurch gekennzeichnet,** daß parallel zum Widerstand (R4) der Kondensator-Widerstands-Reihenschaltung (C1, R4) eine Diode (D3) vorgesehen ist in einer Polung, derart, daß der nichtinverierende Eingang (ROP) potentialmäßig nicht unterhalb der negativen Betriebsspannung (UB) gelangt.

## Claims

1. A non-contact proximity switch having a sensor (SR), fed by a constant voltage source (UB) from a distance through a two-wire line (ZL), able to have its electrical properties affected by metal parts, whose sensor voltage (US), able to altered upon interference, controls an electronic threshold switch which is also connected to the two-wire line and accepts any interference with an altered current input, characterised in that an operational amplifier (OP) is provided as threshold value switch, the inverting input (MOP) of which is supplied with the sensor voltage (US), and the non-inverting input (ROP) of which is connected through a first resistor (R1) to a reference voltage source (R0, Z1) and through a second resistor (R2), in series with a first diode (D1) to the output (AOP) of the operational amplifier (OP) which is connected on the output side through a third resistor (R3) to the positive potential lead of the two-wire line (ZL), in that the output (AOP) of the operational amplifier (OP) is further connected through a capacitor-resistor series connection (C1, R4) to the negative potential lead of the two-wire line (ZL), and in that the connection point of this resistor-capacitor series connection is connected through a second diode (D2) to the non-inverting input (ROP) of the operational amplifier, whereby this diode (D2) is connected such that it blocks the current flow from the reference voltage source (R0, Z1) through the first resistor (R1) and the resistor (R4) of the capacitor-resistor series connection (C1, R4) to the negative potential lead of the two-wire line (ZL).

2. A non-contact proximity switch according to claim 1, characterised in that the voltage at the noninverting input (ROP) of the operational amplifier (OP) is limited to a predetermined value by a Zener diode (Z2).

3. A non-contact proximity switch according to claim 1 or 2, characterised in that a diode (D3) is provided, parallel to the resistor (R4) of the capacitor-resistor series connection (C1, R4), in a polarity such that the non-inverting input (ROP) does not reach potentially below the negative operational voltage (UB).

## Revendications

1. Interrupteur de proximité sans contact comportant un capteur (SR), qui est alimenté à distance par l'intermédiaire d'une ligne bifilaire (ZL) à partir d'une source de tension continue (UB) et dont les propriétés électriques peuvent être influencées par des parties métalliques et dont la tension (US), qui peut varier sous l'action d'une influence, commande un commutateur électronique à valeur de seuil qui est également raccordé à la ligne bifilaire et qui accuse réception de chaque influence au moyen d'une modification de l'absorption de courant, caractérisé par le fait qu'il est prévu comme commutateur à valeur de seuil un amplificateur opérationnel (OP), à l'entrée inverseuse (MOP) duquel est envoyée la tension (US) du capteur et dont l'entrée non inverseuse (ROP) est raccordée, par l'intermédiaire d'une première résistance (R1), à une source de tension de référence (R0, Z1) et par l'intermédiaire d'une seconde résistance (R2) en série avec une première diode (D1), à la sortie (AOP) de l'amplificateur opérationnel (OP), qui est reliée, côté sortie, et par l'intermédiaire d'une troisième résistance (R3), au conducteur, qui véhicule le potentiel positif, de la ligne bifilaire (ZL), que la sortie (AOP) de l'amplificateur opérationnel (OP) est en outre raccordée, par l'intermédiaire d'un circuit série condensateur-résistance (C1, R4), au conducteur, qui est placé au potentiel négatif, de la ligne bifilaire (ZL) et que le point de jonction de ce circuit série résistance - condensateur est raccordé, par l'intermédiaire d'une seconde diode (D2), à l'entrée non inverseuse (ROP) de l'amplificateur opérationnel, cette diode (D2) étant branchée de manière à bloquer le flux de courant qui est transmis de la source de tension de référence (R0, Z1), par l'intermédiaire de la première résistance (R1) et de la résistance (R4) du circuit série condensateur-résistance (C1, R4), au conducteur de la ligne bifilaire (ZL), qui est placé au potentiel négatif.

2. Interrupteur de proximité sans contact suivant la revendication 1, caractérisé par le fait que la tension, qui apparait à l'entrée non inverseuse (ROP) de l'amplificateur opérationnel (OP), est limitée par une diode Zener (Z2) à une valeur prédéterminée.

3. Interrupteur de proximité sans contact suivant la revendication 1 ou 2, caractérisé par le fait qu'en parallèle avec la résistance (R4) du circuit série condensateur-résistance (C1, R4), il est prévu une diode (D3) polarisée de telle sorte que le potentiel présent à l'entrée non inverseuse (ROP) ne tombe pas en-dessous de la tension de service négative (UB).
